# EUROPEAN PATENT SPECIFICATION

(11) **EP 2 340 560 B1**
(45) Date of publication and mention of the grant of the patent: **10.07.2013**
(21) Application number: 08705437.5
(22) Date of filing: 25.01.2008
(51) Int. Cl.: H01L 25/18, H01L 25/07

(54) **POWER SWITCHING MODULE**
LEISTUNGSSCHALTMODUL
MODULE DE COMMUTATION DE PUISSANCE

(43) Date of publication of application: 06.07.2011
(73) Proprietor: Letrika Lab d.o.o., 5290 Sempeter pri Gorici (SI)
(72) Inventor: TRONTELJ, Janez, 1000 Ljubljana (SI); PODRZAJ, Jurij, 1292 Ig (SI)
(86) International application number: PCT/SI2008/000006
(87) International publication number: WO 2009/093982

(56) References cited:
- EP-A- 0 427 143
- EP-A- 1 755 163
- DE-A1- 10 011 633
- DE-A1-102004 057 421
- DE-T2- 60 127 027
- US-A- 5 616 955
- US-B1- 6 353 258
- US-B1- 6 359 331

## Description

The presented invention belongs to the technical domain of electricity, especially to details of semiconductor circuitry for switching electric motors. It shows a new arrangement for conducting electrical current that reduces parasitic resistance and inductance. It improves cooling and ventilating especially by shaping. The structure eases the transfer of heat by flowing fluids, especially by air. The involved structures are power semiconductor devices carrying conductors and electronics carrying plates for control electronics and buffering capacitors.

Power semiconductor devices (MOSFETs or IGTBs) are soldered or bonded on a special three-dimensional lead frame structure. The module improves the efficiency of motor drives by reducing the switching losses, the Joule losses. It optimizes the cooling and allows smaller construction sizes.

### PRIOR ART - STATE OF THE ART

A huge amount of different power modules have been designed with different topology and constructive approach and published in the past. Typical half bridge circuits of power semiconductor devices are controlled by their Gate or Base connections. These bridges are embodied as a series circuit of power semiconductor devices, preferably insulated Gate bipolar transistors (IGBTs). Diodes are connected antiparallel to the switches. The bridges represent the switched current power source to drive the highly inductive loads. One Drain (Collector) and one Source (Emitter) are contacting the supply voltages different potentials. Typical power semiconductor modules have a plurality of screw connections for mounting on flat bodies that are working as heat sinks.

EP 1 755 163 A1 discloses a module comprising a three-dimensional arrangement of conductors.

DE 100 11 633 A1 shows a module which has three half bridge circuits inside one housing that represents a three phase full bridge circuit especially for driving the coils of an electric motor. This typical design shows that on a base plate, a number of conductive areas is used, where the areas are of certain thickness and contacted by connection means. To transport the heat, copper-ceramic-copper layers (direct bonded copper substrates e.g. of beryllium oxide) are used for substrates and to insulate the transistors. These ceramic sandwiches are soldered to a base plate and this may be fixed by screws to additional cooling means. The structure is mainly two-dimensional organised. The problems of locally different heating are solved by dividing the placing area for transistors and diodes like a chess-board where structures with similar thermal behaviour are not directly neighboured.

DE 601 27 027 T2 shows a three-dimensional arrangement of conductors separated by insulator layers. The idea here is to reduce the inductivity of the wiring due to antiparallel current flow through parallel and capacitively buffered conductor planes.

US 6,353,258 B1 and US 5,616,955 uses main electrodes for the Collector and Emitter of the transistors that are placed above the base plate crossing the air.

US 6,359,331 B1 presents a high power switching module having lead frame terminal posts extending away from a substrate. The interconnection scheme shown here shall minimize stray inductance. In a top plate at least one capacitor is placed, conductive and insulating layers are alternating, also an air distance is foreseen below the top plate. The transistors are placed on a base plate consisting of several layers. Co-planar negative and positive rail layers and a phase out layer are above and insulated against each other. Every layer is connected to a certain terminal post to provide electrical connection.

DE 10 2004 057 421 show a pressure contacted power semiconductor module for high environmental temperatures. Strip like connection elements are sintered onto the contact areas of a base plate, further contacts are pressed towards contact planes with spring force (due to the tension of a housing cover).

EP 427 143 B1 is another example for three-dimensional interconnection that shall reduce the inductance. Close and parallel to each other placed conductor stripes are used to make the interconnection to the supply of the semiconductor carrying plate and the load line.

### TASK OF THE INVENTION

Considering the state of the art, a new topology for power switching modules has been looked for combining the positive effects of the prior art and allowing even improved performance. The module shall allow very small constructive size. Reduced power dissipation was wanted for increasing the power efficiency. The temperature increase should be controlled through better and faster heat radiation over cooling means. Cooling and current supply should be best combined. The constructive elements should be very simple, easy to produce and to combine. Assembly and disassembly should be simple and fast. The risks for failure should be minimized. Test and maintenance should be eased. Problematic materials should be avoided. The current paths should be as short as possible; the area of them should have a reasonable size. Insulation material should be avoided to prevent problems due to different temperature extension coefficients. Space should be introduced to improve the cooling by environmental air. As a special consideration a web formation of the interconnection network should be considered, allowing shorter distances between capacitors power supply and the transistors. A special non-contacting double grid structure shall be applied.

### SUMMARY OF THE INVENTION

The tasks of the invention are solved by the invention characterized in the presented claims. Proposed is a power switching module according to claim 1 that has three major constructive domains.

The first domain comprises a base plate which has a number of thermal and electrical contact areas at least at one side.

The second constructive domain represents a three-dimensionally structured interconnection network. This is made of two one in-another interwoven conductive structures and at least three conductors that are assigned for the output loads. Here four load conductors are preferred. Also more load conductors are possible, if required. So also more than one power loads could be driven, like more than one electromotor.

The load conductors are distanced from each other laterally. They are also distanced from the two interwoven conductive structures. The structures may be comparable to a web of to grids that don't touch each other.

The three-dimensionally structured interconnection network uses mainly three layers. The interwoven conductive structures have parts within all layers. The load conductors are bridged by these web-like interwoven conductive structures and are located only in the bottom layer.

These load conductors are separated by air gaps from the structures and hence do not lie side by side. In the advantageous configuration all load conductors are neighboured by parts of the interwoven conductive structures above and along two opposite sides.

This second domain of the power switching module may be constructed out of one material only, preferably copper.

The third constructive domain comprises a top plate. This is a carrier for electrical capacitors. The capacitors are distributed across the surface of the plate and store a big amount of electrical charge to support a supply source. The top plate comprises electrical contact areas on the side which is facing the interconnection network. These contact areas are foreseen to closely contact the top of the interconnection network.

At least a pairs of power semiconductor devices are the required active switching components of the power switching module. Each semiconductor device is used to switch a first or a second electrical potential to the load conductors to drive loads which are contacted to them. The electrical potentials are caused by a power supply contacted at defined points to the interwoven conductive structures, but also by the permanently loaded capacitors of the top plate.

One semiconductor device of each pair is placed at one of the interwoven conductive structures and contacts this one with at least one first connection mean. At least one other connection mean of this first semiconductor device is contacting one of the load conductors.

The second semiconductor device of at least one pair is placed at one of the load conductors with at least one first connection mean. At least one other connection mean of this second semiconductor device is contacting the other conductive structure of the two one in-another interwoven conductive structures. Depending on the type of the semiconductor device, the placement may be different. Important is, that one Source-Drain or one Emitter-Collector-path is switched by one Gate in order to link one current path to one supply voltage potential. As the conductive structure is very close to the power semiconductor element contact and also very close to the capacitor contacts, the current path for each switched power semiconductor device is reduced to an extreme minimum, respecting the cooling requirements.

To achieve best performance, the three-dimensional network may comprise at least three constructive layers:

A first layer or bottom layer consists of laterally distanced conductors. Each conductor is assigned either to one of two different electrical potentials or to one of the required output load conductors. Each conductor, which is assigned to an output current path, need to be neighboured by at least two conductors that are assigned to different electrical potentials.

A second layer consists of conductive material to join conductors of the first layer and conductors of the third layer, namely these conductors that are assigned to the same electrical potential. The shape of the material in this layer is used to separate differently assigned conductors of the first from the third layer causing sufficient air gaps between them.

A third layer or top layer consists of laterally distanced conductors comparable to the first layer but with substantial different orientation. In this layer each of the conductors is assigned to one of two different electrical potentials.

Preferably at least one end of the two conductors which are assigned to one of two electrical potentials and at least one end of each assigned load conductor are shaped to connectors for the first battery contact, the second battery contact and the load contacts.

The loads may be three phase motor-coils. A fourth load may be used as reserve or for additional loads or for four phase motor coils.

The conductors of the first and third layer have a major expansion. This means the length of these conductors is larger than the width and the thickness. The orientation of the major extension of the conductors in the third layer is substantially different to the orientation of the major extension of the conductors in the first layer. This allows a structure with alternating assigned conductors to the two different electrical potentials in the top layer, while the bottom layer may be organised by having each load conductor surrendered by both electrical potentials. This allows minimizing the electrical current paths for the power semiconductor devices and the capacitors and maximizing the thermal transport to thermal capacitors and dissipation.

Advantageous are conductors that form stripes of substantially constant and equal thickness. The major extension orientation of the conductors of the first layer should be parallel and substantially orthogonal to those of the third layer.

In some cases it might be of advantage if either the conductors of the first layer or the conductors of the third layer are radially orientated. If the conductors of the first layer are radially oriented then the conductors of the third layer may have substantially a shape of coaxial circle rings. If the conductors of the third layer are radially oriented, then the conductors of the first layer substantially have a shape of circle rings.

Beside constant thickness a constant width of the conductors along their length may be advantageous.

In order to fit the three constructive domains together at least some of the contact areas of the base plate are parallel and have at least approximately the same size and shape to some areas of the bottom of the three-dimensional network.

Other contact areas of the base plate are not contacting the network but the bottom of the load conductors. This contacting method allows a good thermal bridge to the cooling base plate and contact opportunities for further cooling structures.

The third constructive domain is contacting the top of the three-dimensional network through the contact areas on the bottom of the top plate. To fit to these areas, the three-dimensional network has equivalently shaped areas with approximately the same size as the contact areas of the top plate.

As the capacitors are placed at the top of the top plate, holes or vias are required to wire the capacitors through the plate with the contact areas on the bottom of the top plate.

It is sense full that the base plate carries the low power control electronic components or an electric connector for controlling electronics.

If required, also diodes may be placed parallel to the power semiconductor devices between the load conductors and the interwoven conductive structures.

Simple constructions can be made using flat plates like PCB (printed circuit boards), but sometimes it may be advantageous to form the plates cylindrical or spherical e.g. to fit in special housings.

For good conductivity all electrical contact areas of the plates, the interwoven conductive structures and the load conductors are made of the same material to prevent thermal tensions due to different expansion coefficient, suitable is metal, preferably copper.

The interwoven highly conductive structures are advantageously constructed out of one piece. Processes like etching or milling could be used for forming. Alternatively or supplementary the shaping may be done by bending.

The linking elements in the second layer to contact the elements of the first to the third layer could be welded and/or soldered to achieve good electrical contact zones. By bending zones of the conductors of the first or the third layer into the second layer, the merging at the contact places is simple.

It is also possible to assemble and force parts together with riveting or screws. With the help of screws, washers and nuts, the contact areas are pressed together. These means also serve as thermal sinks as they represent a big thermal capacitor.

Soldering means are recommended between the contact areas.

With the help of close housings or mechanical springs the contact areas may be pressed together without soldering too. In this case conductivity paste preferably adhesive silver conductivity paste may improve the layer transitional resistance.

Magnets for fixing the parts together enable a comfortable way for assembling and disassembling the three different domains.

For contacting the Gate or Base connections of the power semiconductor devices bond pads are positioned on top of the base plate and routed to the electronics or to a connector. The bond wires are led through the air gaps of the three-dimensionally structured interconnection network.

Instead of bond wires between the second and the third domain, the Gate or base connection of each power semiconductor device may be contacted by a controlling output of transponder-like - addressable integrated circuit. This integrated circuit is favourably supplied by the interwoven highly conductive structures and has a wireless interface for addressing.

Suitable is an optical data input interface on the integrated circuit for addressing by a pulsed light source. This light source may be placed on the base plate and controlled by controlling electronics. Diffuse reflective light is reaching the light sensitive element of the integrated circuits.

An advantageous alternative instead of addressing by light would be capacitively addressing an address decoder input of the integrated circuit. In this case, capacitively coupling structures which are placed parallel to and isolated against the interwoven highly conductive structures are used. On each structure, the output of an addressing controller device may be capacitively connected, causing a common mode signal on the electrical potentials.

The innovation is detailed described in following preferred embodiments:
**Fig.**1 shows an example of the power switch module in perspective view, without housing or additional cooling elements.
**Fig.**2 shows the example of **Fig.**1 without the top plate and without screws.
**Fig.**3 shows the example of **Fig.**1 with separated components.
**Fig.**4 shows the conductive structures in a non-interwoven drawing.
**Fig.**5 and Fig.6 show another example forming the three-dimensionally structured interconnection network; here with unbent flat conductive stripes for the first and third layer and thin squares of conductive material for the second layer. **Fig.**5 is represents the top view and
**Fig.**6 the side view of the cut **5-5'** in **Fig.**5.
**Fig.**7 is a further example for the three-dimensionally structured interconnection network in polar coordinates.
**Fig.**8 shows the schematic of the circuitry (Prior Art).
**Fig.**9 shows the circuit diagram including parasitic inductance and resistance per length.

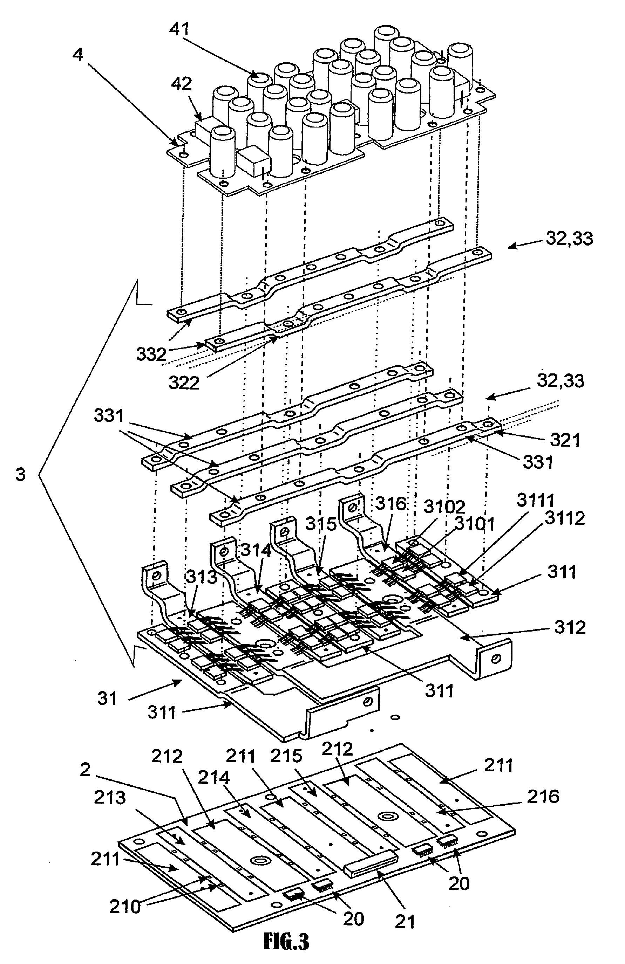

The presented new power switch module 1 consists of three major domains as they are shown in the disassembled view **Fig.3****.** These domains are a base plate 2, a three-dimensional network structure 3 and a top plate 4.

Starting from bottom up, the base plate 2 in Fig.3 is a rectangular flat plate of thin electrical isolating material or it may be a metal plate with a coated or applied isolation layer. Ceramics and a large other of electrical isolating materials (synthetic fabricated) may be used. Well suitable materials have high electrical isolation resistor but good thermal conductivity. This plate is isolating the high power electrical path against the cooling structures that may be mounted below the plate and on the bottom of the plate for heat sink or heat dissipation. It is also possible to use a thin isolating plastic foil of less than 0.5 mm thickness for electrical insulation. On top of the isolation layer a number of large contact areas 211-216 are applied. Copper foils are well suited. Small bond pads 210 for the Base or Gate-interconnection by wires are placed between the big contact areas. The functions of the big areas are thermal Energy transport and output signal contact. All bond pads are routed (here not visible) to an electric connector (interface) 21 or to electronic components 20 to form the low power control logic block. Typically pulse width modulated signals are generated to switch the power semiconductor devices of the module. The signals on the areas 213,214,215 and 216 are the load input signals at the motor coil connections u,v,w (and x for reserve or further power equipments). Each of these load signal stripes are neighboured by power supply stripes which assigned to two different supply voltage potentials. The structure of the base plate may also be made with PCB (printed circuit board) material.

Another plate 4 is on top of the power switch module. This plate has nearly the same size as the base plate 2 discarding some holes or mounting areas for screws. On the top of this plate 4 there are a large number of capacitors, here 22 electrolytic capacitances 41 and six non electrolytic (e.g. polyester-) capacitances are engaged. These capacitors shall deliver as fast as possible very much amount of charged potential energy, to support the battery. The bottom of the top plate is not shown. There also a number of copper foil contacting areas are placed. The orientation of these areas is substantially different to the orientation of the base plate 2, ideal orthogonal to each other. The shapes of the contacting areas on the top plate are a mirror to the top surface of the three-dimensional interconnection network 3. Here 12 rectangular fields must be assumed. Along the width of the top plate the copper fields are assigned to alternating polarity according to the two different used potentials. All capacitors are wired through the top plate (e.g. by vias) through wire-connections to the contact areas. The top plate 4 could be like a PCB, too.

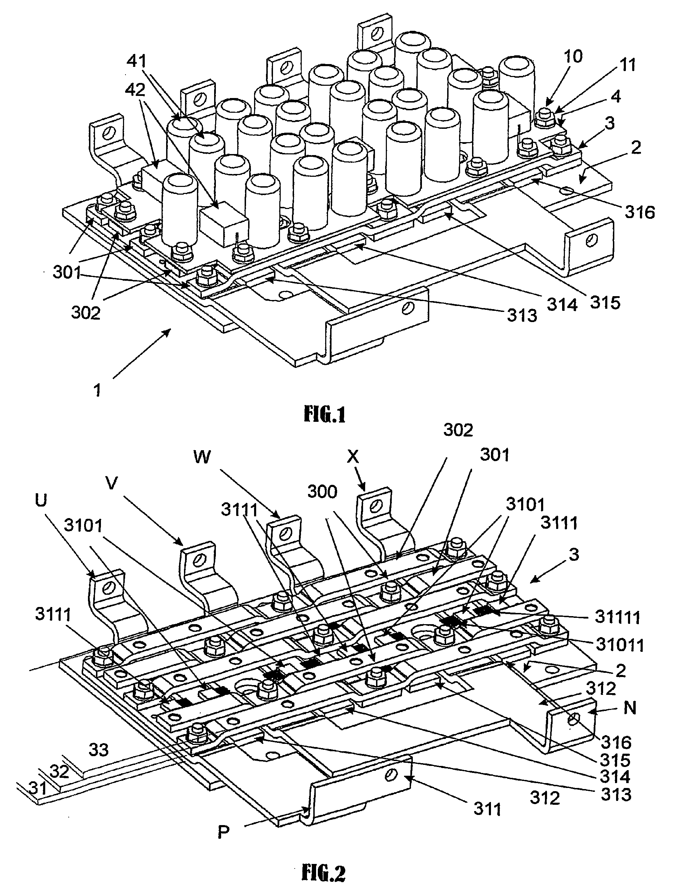

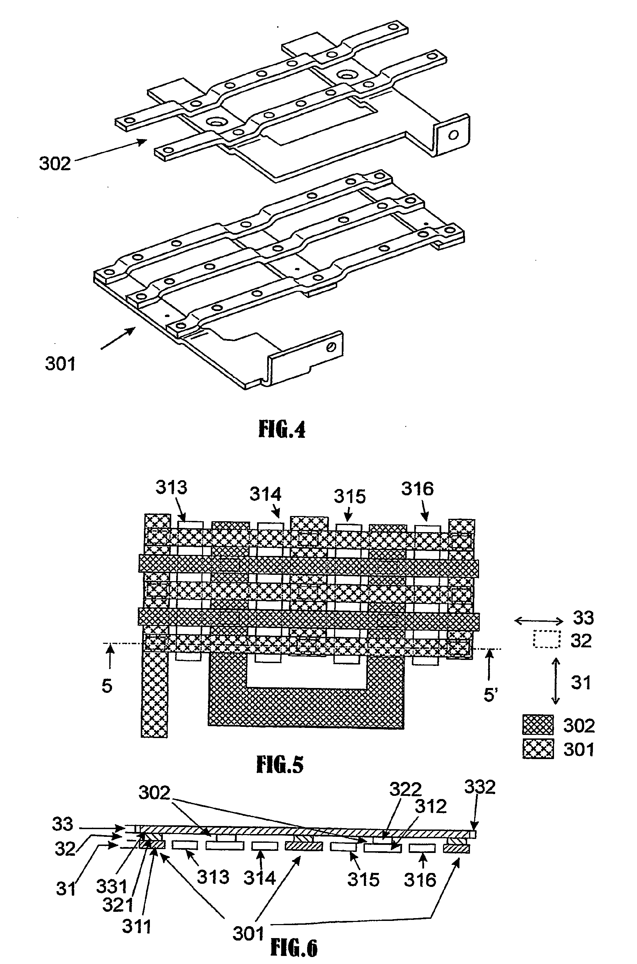

The new and innovative structure is given by the three-dimensional network 3. This network does not need any isolation layer. The isolating material is the dry air around and between the structures. The structure 3 is fragmented shown in **Fig.**3. It consists of conductive material in the shape of stripes that are running in two orthogonal major directions in two distanced layers 31,32. Here the stripes 332,331 of the top layer 33 are mainly parallel to the length of the plates, and the stripes 311-316 of the bottom layer are mainly parallel to the width of the plates. To get a connection through an intermediate layer 32 between the top layer 33 and the bottom layer 31 of the structures, the stripes 332,331 of the top layer 33 are bent to form the bridge feet 321 and 322. Parts 311,321,331 are assigned to a first voltage potential, 312,322,332 are assigned to a second voltage potential. In **Fig.**4 are the resulting conductive structures 301,302 in a not interwoven view to show which stripes have the same potential. In **Fig.**2 the assembled construction of the base plate 2 and the three-dimensionally interconnection network 3 is presented. To fit the stripes together screws and nuts are used here. The two one-in-another interwoven highly conductive structures 301,302 do not contact each other directly. Air and the base plate 2 are the separating media. The stripes 313-316 of the bottom layer 31 of the interconnection network are formed to connectors u,v,w,x for the loads. One stripe 311 is formed to a battery or power supply connectors P and two stripes 312 are combined with a connection cross stripe to form the battery or power supply connectors N. The interconnection network is placed between the plates 2,4 by pressure (through the screws going through the top and bottom plate 2,4 and fixed by nuts). This results in the power module 1 as shown in **Fig.**1. The bending of the strips results in certain amount of spring tension. Additionally some conductive paste or soldering may be put between the base plate 2 and the interconnection network 3 and the top plate 4 and the connection structure 2.

The high power semiconductors are directly placed on the stripes of the bottom layer of the interconnection network. Primary power semiconductor devices 3111 and diodes 3112 are placed on one of the conductive structures 301 and contacting them on the bottom layer 311 and secondary power semiconductor devices 3101 and diodes 3102 are placed on the load contactors 313-316 and contacting them. The load contactors are isolated from all other conductors and directly soldered for fixation on top of the base plate 2 to the contact areas 213-216. Second contact means of the diodes are contacting the neighboured stripe of the same layer. Thus the main path of the diodes and power semiconductor devices bridge the gaps between the load conductors 313, 314, 315 or 316 and the voltage potential conductor 311.

Gate or Base contact wires are fed from the power semiconductor devices through the structures' gap down to the base plate 2 where they are bonded to the bond pads 210.

**Fig.**5 and **Fig.**6 shows another simpler example of the interconnection network 3 in top view and in a section view 5-5'. These figures show the web structure of the interconnecting network consisting of the two interwoven conductive structures 301 and 302 emphasised by different pattern in **Fig.**5. The conductive structures 301,302 have four tunnels like spaces to keep room for the load conductors that need to be placed in the same layer 31. Here distancing means 321,322 are used instead of bent parts of the stripes.

The examples shown in **Fig.**1 to **Fig.**4 are considered to be a best compromise to get good switching performance, minimal energy loss and easy and fast assembly or disassembly for maintenance.

The interconnection network 3 together with the base plate 2 and the screws and nuts represent a good thermal sink, the air gaps in between allow good heat dissipation. Heat accumulation is minimized at the active components. Additional coolers are easily mountable below the base plate. The large number and shape of the capacitors in the top plate 4 also serve as big dissipation area for thermal loss energy.

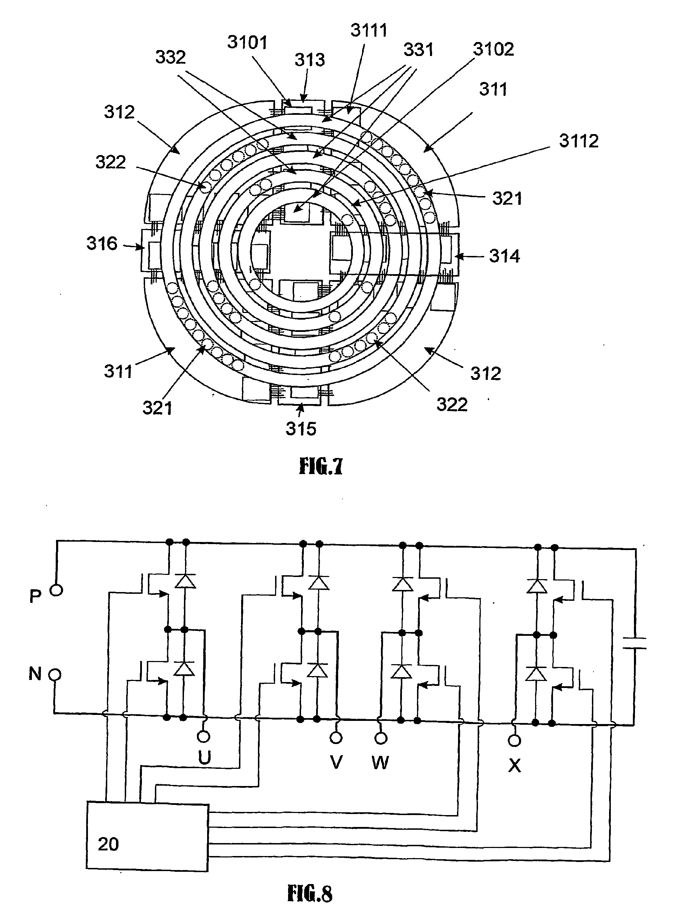

**Fig.**7 shows the top view of an alternative interconnection layer. In this case the base and the top plate may have a disc shape. The top layer 33 of the interconnection network are made of concentric rings 331,332 that are contacted in the intermediate layer 32 by connection means 321,322 (here just to make visible, done by small discs). These means contact four sectors assigned to two voltage potentials 311,312 in the bottom layer 31. The load conductors 313-316 are radially oriented in the bottom layer with the same angular distance between them and are separated by the sectors 311,312.

**Fig.**8 shows the prior art schematic of a strong simplified representation of the circuits shown in **Fig.**1 and **Fig.**7.

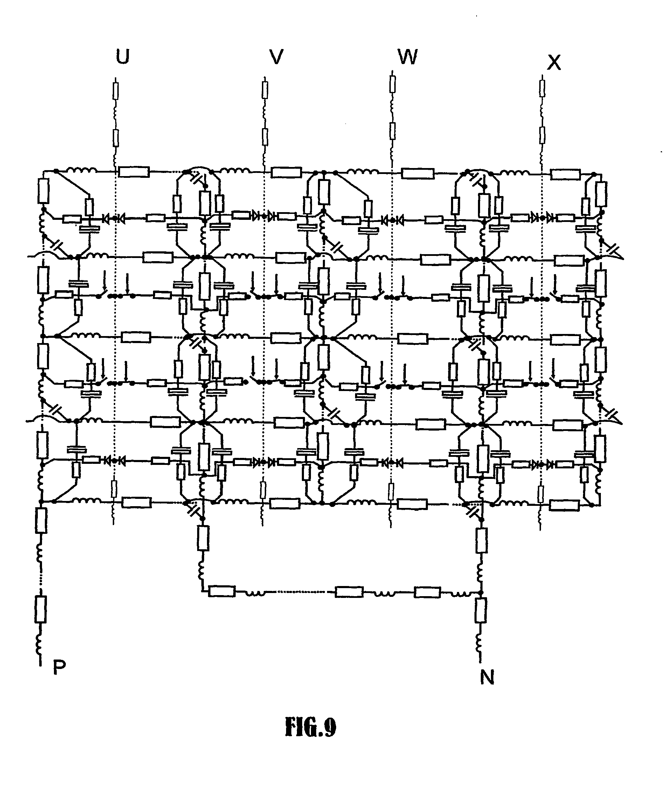

Due to distributed parasitic resistance and inductance per length of the interconnection material as well as due to parasitic capacitance especially at the crossing conductors together with the distributed capacitors across the network the more realistic representation of the Power-Modules circuit diagram is shown in **Fig.**9. Here the big advantages of the presented invention can be quickly and easily understood. Each resistor represents a thermal source that produces heat through power dissipation. The conductors to the power semiconductor devices in the interconnection network, the conductors to the loads, the power semiconductor device (here shown as switches with R_on resistance), the capacitors and the contacts of bond wires and the metal planes on the plates don't have zero parasitic resistance. Power loss in form of heat must be spread through the heat sink (big mass of copper material) and transported to the ambient air (cooling air around the interconnection network and the base and top plate and around the capacitors) to keep the power semiconductor within the required temperature range. As the network is threedimensional and the power semiconductors are spread across this network, the risk of heat accumulation is minimized. Each conductor element and each semiconductor element is surrounded by air, the distances from the potential contacts are short, the section of the conductor quite big, which result in very low parasitic resistance and inductance.

There can also be more P and N contacts in each layer. The u,v,w connections may be also optimised in position and number.

## Claims

1. Power switching module (1) with two distanced and opposite placed plates (2,4) with topically applied electrically and thermally conductive contact areas having main extension on the surfaces facing each other wherein the main extensions of the contact areas (211-216) on the first plate (2) is 90° rotated versus the main extension of the contact areas on the second plate (4) which carries buffering capacitors (41,42), this module (1) comprising electrical and thermal load conductors (313-316), electrical and thermal positive (311) and negative supply conductors (312) with a main extension in a first physical thin layer (31) and surfaces that extensively contact the conductive areas (211-216) on the top of the first plate (2) wherein
• each load conductor (313-316) is laterally distanced and neighboured by one positive supply conductor (311) on one long side and by one negative supply conductor (312) on the other long side inside the first layer (31) and
• each load conductor (313-316) is bridged by laterally distanced and neighboured alternating positive (331) and negative further supply conductors (332) which are positioned in a third physical layer (33) parallel to the first layer (31) wherein the orientation of the main extensions of these supply conductors is rotated by 90° compared to the orientation of the conductors in the first layer (31) and wherein surfaces of the further supply conductors extensively contact the conductive areas on the bottom of the second plate (4) and
• each positive and negative further supply conductor (331, 332) is contacted or joined to conductive parts (321, 322) in a second physical layer (32) and wherein the conductive parts connect the corresponding further supply conductors (331, 332) of the third layer (33) with the supply conductors (311, 312) of the first layer (31) but also space the parts of the conductors in the first and third layer that not correspond by causing air gaps and
• pairs of power semiconductor devices (3111, 3101) wherein one semiconductor device (3111) of each pair is placed at a positive supply conductor (311) and contacting it with at least one first connection mean and at least one other connection mean (31111) of the semiconductor device is contacting one of the load conductors (313-316) or conversely, and wherein the second semiconductor device (3101) of the pair is placed at one of the load conductors (313-316) with at least one first connection mean and at least one other connection mean (31011) is contacting a negative supply conductor (312) or conversely.

2. Power switching module of claim 1 wherein at least one end of each supply and further supply conductor (311, 312, 321, 322, 331, 332) and at least one end of each load conductor (313-316) are formed to connectors (P,N,u,v,w,x) for a positive battery contact (P), a negative battery contact (N) and load contacts (u,v,w, x) outside the edge of the plates (2, 4).

3. Power switching module of claims 1 or 2 wherein the conductors (311-316; 331, 332) form stripes of substantially constant and equal thickness and a constant width along their length.

4. Power switching module of one of the claims 1 to 3 wherein either the conductors (311-316) of the first layer are radially oriented and the conductors (331, 332) of the third layer substantially have the shape of circle rings or the conductors (331, 332) of the third layer are radially oriented and the conductors (311-316) of the first layer substantially have the shape of circle rings.

5. Power switching module of one of the claims 1 to 4 wherein each capacitor (41, 42) is contacting a pair of the contact areas on the second plate (4) through via holes in the second plate (4). H

6. Power switching module of one of the claims 1 to 5 wherein the first plate (2) is a carrier for electronic components (20) and/or an electric connector (21).

7. Power switching module of one of the claims 1 to 6 comprising diodes (3102, 3112) between the load conductors (313-316) and the supply and further supply conductors (311, 312, 321, 322, 331,332).

8. Power switching module of one of the claims 1 to 7 wherein the plates (2, 4) are flat, cylindrical or spherical.

9. Power switching module of one of the claims 1 to 8 wherein all electrical contact areas and the load conductors (313-316) and the supply and further supply conductors (311, 312, 321, 322, 331, 332) are made of metal preferably made of copper.

10. Power switching module of one of the claims 1 to 9 wherein the the supply conductors are constructed of bent, welded and/or soldered parts or parts that are mounted and forced together with riveting or screws (300).

11. Power switching module of one of the claims 1 to 10 wherein the first plate (2), the supply conductors the further supply conductors (311, 312, 322, 331, 332), the load conductors (313-316) and the second plate (4) are mounted together by
• soldering means, or
• pressure against each other with the help of close housings preferably supported by spring tension or
• screws (10) with nuts (11), wherein both serve as thermal sink, or
• conductivity paste preferably adhesive silver conductivity paste or
• through magnets
or combinations of these means.

12. Power switching module of one of the claims 1 to 11 wherein the first plate (2) comprises electrically routed bond pads (210) for gate or base connections of the power semiconductor devices (3111, 3101) and wherein the connections are bonded through the air gaps between the structures of the supply and further supply conductors in the first (31), second (32) and third layer (33).

13. Power switching module of one of the claims 1 to 12 wherein the gate or base connection of each power semiconductor device (3111, 3101) is contacted by the controlling output of an integrated circuit which is favourably supplied by the supply and further supply conductors (311, 312, 321, 322, 331, 332) to switch the semiconductor devices and wherein the integrated circuit has a wireless interface.

14. Power switching module of claim 13 wherein the integrated circuit comprises an optical data input interface for being addressed by a pulsed light source.

15. Power switching module of claim 13 wherein an address decoder input of an integrated circuit is connected to capacitively coupling structures which are placed parallel to and isolated against the supply conductors and against the further supply conductors and to which the output of an addressing controller device is capacitively connected, causing a common mode signal on the electrical potentials.

## Patentansprüche

1. Das Leistungsschaltmodul (1) mit zwei auseinander- und sich gegenüberliegenden Platten (2, 4) mit lokal genutzten strom- und wärmeleitenden Berührungsoberflächen, die den Hauptanschluss auf der ihnen gegenüberliegenden Oberfläche haben, wobei der Hauptanschluss der Berührungsoberflächen (211-216) auf der ersten Platte (2) um 90° gedreht zum Hauptanschluss der Berührungsoberflächen der zweiten Platte ist (4), die abschwächende Kondensatoren tragen (41, 42), dieses Modul beinhaltet elektrische Leitern und Leitern mit Wärmebelastung (313-316), elektrische und positive (311) und negative Wärme Versorgungsleitern (312) mit dem Hauptanschluss in der ersten physikalischen dünnen Schicht (31) und mit Oberflächen, die sich weitreichend mit den leitenden Oberflächen (211-216) oberhalb der ersten Platte (2) berühren, wobei
• jeder Belastungsleiter (313-316) an einer Längsseite in bestimmtem Abstand mit einem positiven Versorgungsleiter (311) und an der anderen Längsseite mit einem negativen Versorgungsleiter (312) innerhalb der ersten Schicht (31) umgeben ist und
• jeder Belastungsleiter (313-316) an der Seite in bestimmtem Abstand abwechselnd mit einem positiven Versorgungsleiter (331) und einem weiterführenden negativen Versorgungsleiter (332) umgeben ist, die sich in der dritten physischen Schicht befinden (33) parallel zur ersten Schicht (31), wo sich die Hauptanschlüsse der Versorgungsleitern befinden, die im Vergleich zu der Richtung der Leitern in der ersten Schicht (31) um 90° gedreht sind und wo die weiterführenden Versorgungsleitern weitreichend die leitende Oberfläche am Boden der zweiten Platte berühren (4) und
• jeder positive und negative weiterführende Versorgungsleiter (331, 332) berührt die leitenden Teile in der zweiten physischen Schicht (32) oder ist sogar mit diesen verbunden (331, 332) und wo die leitenden Teile entsprechende weiterführende Versorgungsleitern (331, 332) der dritten Schicht (33) mit Versorgungsleitern (331, 332) der ersten Schicht (31) verbinden und mit hervorgerufenen Luftritzen auch den Abstand unpassender Teile der Leitern der ersten und dritten Schicht bilden, und
• Paare elektrischer Halbleiteranlagen (3111, 3101), bei denen eine Halbleiteranlage (3111) jedes Paares an dem positiven Versorgungsleiter angebracht ist (311) und diese mit mindestens einem Erstanschluss berührt, mindestens ein weiterer Anschluss (31111) der Halbleiteranlage berührt einen der Belastungsleitern (313-316) oder umgekehrt und dabei ist die zweite Halbleiteranlage (3101) dieses Paares mit mindestens einem Erstanschluss auf einem der Wetterleitern angebracht (313-316), mindestens ein weiterer Anschluss (31011) berührt den negative Versorgungsleiter (312) oder umgekehrt.

2. Ein Leistungsschaltmodul aus Punkt 1 der Anforderungen, bei dem mindestens ein Ende jedes Versorgungs- und jeder weiterführenden Versorgungsleiters (311, 312, 321, 322, 331, 332) und mindestens ein Ende jedes Belastungsleiters (313-316) in eine Anschlussklemme (P, N, u, v, W, x) für den positiven Batterien Kontakt (P), für den negativen Batterien Kontakt (N) und für die Belastungskontakte (u, v, w, x) außerhalb des Plattenrandes (2, 4) gestaltet ist.

3. Ein Leistungsschaltmodul aus Punkt 1 oder 2 der Anforderungen, bei dem die Leitern (313-316; 331, 332) ziemlich gleichmäßige Bänder gleicher Stärke und gleichmäßiger Breite entlang ihrer Länge bilden.

4. Ein Leistungsschaltmodul aus einer der Anforderungen aus den Punkten 1 bis 3, bei dem entweder die Leitern (311-316) der ersten Schicht radial verdreht sind und die Leitern der dritten Schicht (331, 332) kreisförmig gestaltet sind, oder die Leitern (331, 332) der dritten Schicht radial verdreht sind und die Leitern der ersten Schicht (311-316) kreisförmig gestaltet sind.

5. Ein Leistungsschaltmodul aus einer der Anforderungen aus den Punkten 1 bis 4, bei dem jeder Kondensator (41, 42) ein Paar Berührungsoberflächen der anderen Platte (4) über die Öffnungen auf der anderen Platte verbindet (4).

6. Ein Leistungsschaltmodul aus einer der Anforderungen aus den Punkten 1 bis 5, bei dem die erste Platte (2) die elektronischen Komponenten (20) bzw. eine elektrische Anschlussklemme (21) trägt.

7. Ein Leistungsschaltmodul aus einer der Anforderungen aus den Punkten 1 bis 6, dass eine Diode (3102, 3112) zwischen den Belastungsleitern (313-316) den Versorgungsleitern und den weiterführenden Versorgungsleitern (311, 312, 321, 322, 331, 332) beinhaltet.

8. Ein Leistungsschaltmodul aus einer der Anforderungen aus den Punkten 1 bis 7, wo die Platten (2, 4) flächig, zylindrisch oder rund sind.

9. Ein Leistungsschaltmodul aus einer der Anforderungen aus den Punkten 1 bis 8, bei dem alle elektrischen Berührungsflächen und Belastungsleitern (313-316) sowie die Versorgungsleitern und die weiterführenden Versorgungsleitern (311, 312, 321, 322, 331, 332) aus Metall, nach Möglichkeit aus Kupfer sind.

10. Ein Leistungsschaltmodul aus einer der Anforderungen aus den Punkten 1 bis 9, bei dem die Versorgungsleitern aus abgewinkelten, geschweißten bzw. gelöteten Teilen oder aus Teilen bestehen, die befestigt und mit Nieten oder Schrauben verbunden sind (300).

11. Ein Leistungsschaltmodul aus einer der Anforderungen aus den Punkten 1 bis 10, bei dem die erste Platte (2), die Versorgungsleitern und die weiterführenden Versorgungsleitern (311, 312, 321, 322, 331, 332), die Belastungsleitern (313-316) und die zweite Platte (4) miteinander verbunden sind
• durch Lötungen, oder
• zusammengedrückt in einem eng anliegenden Gehäuse, nach Möglichkeit mit Unterstützung von Federspannung, oder
• mit Schrauben (10) mit Muttern (11), bei denen beide Wärmeableitung bedeuten, oder
• mit Leitpaste, nach Möglichkeit mit einer klebenden silbernen Leitpaste oder
• mit Magneten
oder mit einer Kombination aller Mittel.

12. Ein Leistungsschaltmodul aus einer der Anforderungen aus den Punkten 1 bis 11, bei der die erste Platte (2) die elektrischen richtungsgebenden Verbindungskissen (210) für die Ausgangs- und Grundanschlüsse der elektrischen Halbleiteranlagen umfassen (3111, 3101) und bei der die Anschlüsse mit Luftschlitzen zwischen den Strukturen der Versorgungsleitern und weiterführenden Versorgungsleitern in der ersten (31), der zweiten (32) und der dritten (33) Schicht verbunden sind.

13. Ein Leistungsschaltmodul aus einer der Anforderungen aus den Punkten 1 bis 12, bei dem der Ausgangs- oder Grundanschluss der einzelnen Halbleiteranlagen (3111, 3101) in Kontakt mit dem Hauptausgang des integrierten Schaltkreises steht, die die Versorgungsleitern und die weiterführenden Versorgungsleitern (311, 312, 321, 322, 331, 332) für die Umschaltung der Halbleiteranlagen versorgen, und das ein integrierter Schaltkreis mit einer kabelfreien Schnittschnelle hat.

14. Ein Leistungsschaltmodul aus Punkt 13 der Anforderungen, bei dem der integrierte Schaltkreis eine Schnittstelle zur Eingabe optischer Daten umfasst, die auf eine pulsierende Lichtquelle reagiert.

15. Ein Leistungsschaltmodul aus Punkt 13 der Anforderungen, bei dem der Eingang des Adressdecoders des integrierten Schaltkreises an die Kapazität der Verbindungsstrukturen angeschlossen ist, die parallel angeordnet sind und so von den Versorgungsleitern und den weiterführenden Versorgungsleitern isoliert ist und an deren Kapazität der Ausgang der Adresskontrollanlage angeschlossen ist, die ein Gleichtaktsignal der elektrischen Potenziale hervorruft.

## Revendications

1. Module de commutation de puissance (1) à deux plaques (2, 4) séparées et opposées, aux zones conductrices de l'électricité et de la chaleur au contact, utilisées localement, à l'extension principale sur les surfaces opposées, avec les extensions principales des zones de contact (211-216) sur la première plaque (2) tournées de 90° vers l'extension principale des zones de contact sur la seconde plaque (4) portant les condensateurs d'amortissement (41, 42), ce module (1) comprend les conducteurs électriques et thermiques (313-316), les conducteurs d'alimentation électriques et thermiques positifs (311) et négatifs (312) avec l'extension principale dans la première couche physique mince (31) et aux surfaces au contact extensif avec les zones conductrices (211-216) à la surface supérieure de la première plaque (2), où
• chaque conducteur de charge (313-316) est du côté muni d'un conducteur d'alimentation positif (311) sur un côté longitudinal et d'un conducteur d'alimentation négatif (312) sur l'autre côté longitudinal à l'intérieur de la première couche (31) et
• chaque conducteur de charge (313-316) est du côté à une certaine distance shunté de manière alternative par le conducteur d'alimentation positif (331) et par le conducteur d'alimentation négatif successif (332), positionnés dans la troisième couche physique (33) parallèle à la première couche (31) où les extensions principales de ces conducteurs d'alimentation sont tournées de 90° par rapport à la direction des conducteurs dans la première couche (31) et où les surfaces des conducteurs d'alimentation successifs touchent extensivement les zones conductrices au fond de la seconde plaque (4) et
• chaque conducteur d'alimentation positif et chaque conducteur d'alimentation négatif successif (331, 332) touche ou est joint aux parties conductrices (331, 332) dans la seconde couche physique (32) et où les parties conductrices relient les conducteurs d'alimentation successifs correspondants (331, 332) de la troisième couche (33) avec les conducteurs d'alimentation successifs (331, 332) de la première couche (31) et également séparent les parties des conducteurs dans la première et dans la troisième couche en produisant les entrefers, et
• les paires de dispositifs semi-conducteurs d'énergie (3111, 3101), où un dispositif semi-conducteur de chaque paire (3111) est positionné sur un conducteur d'alimentation positif (311) et le touche par au moins une première connexion, tandis que au moins une seconde connexion et au moins une autre connexion (31111) du dispositif semi-conducteur est au contact avec un des conducteurs de charge (313-316) ou vice-versa, et où le second dispositif semi-conducteur (3101) de cette paire est monté sur un des conducteurs de charge (313-316) avec au moins une première connexion, tandis que au moins une autre connexion (31011) est au contact avec le conducteur d'alimentation négatif ou vice versa.

2. Module de commutation de puissance de la 1^{ère} revendication où au moins un bout de chaque conducteur d'alimentation et de chaque conducteur d'alimentation successif de la 1^{ère} revendication (311, 312, 321, 322, 331, 332) ainsi qu'au moins un bout de chaque conducteur de charge (313-316) ont la forme de connecteurs (P, N, u, v, W, x) pour un contact de batterie positif (P), pour un contact de batterie négatif (N) et pour les contacts de charge (u, v, w, x) au-delà du bord des plaques (2, 4).

3. Module de commutation de puissance de la 1^{ére} et de la 2^{e} revendication où les conducteurs (313-316; 331, 332) forment les bandes à l'épaisseur assez constante et égale ainsi que de largeur constante le long toute la longueur.

4. Module de commutation de puissance de l'une des revendications de 1 à 3 (311-316) où soit les conducteurs de la première couche sont radialement orientés et les conducteurs (331, 332) de la troisième couche sont de forme circulaire, soit les conducteurs (331, 332) de la troisième couche sont radialement orientés et les conducteurs (311-316) de la première couche sont de forme circulaire.

5. Module de commutation de puissance de l'une des revendications de 1 à 4 où chaque condensateur (41, 42) relie une paire de zones de contact par les trous dans la seconde plaque (4).

6. Module de commutation de puissance de l'une des revendications de 1 à 5 où la première plaque (2) porte les composants électroniques (20) ou un connecteur électrique (21).

7. Module de commutation de puissance de l'une des revendications de 1 à 6 qui comprend les diodes (3102, 3112) entre les conducteurs de charge (313-316) et les conducteurs d'alimentation et les conducteurs d'alimentation successifs (311, 312, 321, 322, 331, 332).

8. Module de commutation de puissance de l'une des revendications de 1 à 7 où les plaques (2, 4) sont plates, cylindriques ou sphériques.

9. Module de commutation de puissance de l'une des revendications de 1 à 8 où les conducteurs de charge (313-316) et les conducteur d'alimentation (311, 312, 321, 322, 331, 332) sont en métal, de préférence en cuivre.

10. Module de commutation de puissance de l'une des revendications de 1 à 9 où les conducteurs d'alimentation sont construits des pièces courbées, soudées ou brasées, fixées et rattachées par les rivets et par les vis (300).

11. Module de commutation de puissance de l'une des revendications de 1 à 10 où la première plaque (2), les conducteurs d'alimentation et les conducteurs d'alimentation successifs (311, 312, 321, 322, 331, 332), les conducteurs de charge (313-316) et la seconde plaque (4) sont fixés ensemble
• par brasage, ou
• par pression réciproque à l'aide des bâtis serrés, préférablement supportés par la tension du ressort, ou
• par les vis (10) aux écrous (11), les deux servant à décharge thermique, ou
• par la pâte de conductivité, préférablement la pâte de conductivité adhésive en argent, ou
• par les aimants
par les combinaisons de ces moyens-ci.

12. Module de commutation de puissance de l'une des revendications de 1 à 11 où la première plaque (2) comprend les coussins de liaison acheminés par l'énergie électrique (210) pour les connexions électriques de sortie ou de base des dispositifs semi-conducteurs (3111, 3101) et où les connexions sont reliées par les entrefers entre les structures des conducteurs d'alimentation et des conducteurs d'alimentation successifs dans la première (31), la seconde (32) et la troisième (33) couche.

13. Module de commutation de puissance de l'une des revendications de 1 à 12 où la connexion de sortie ou de base de chaque dispositif semi-conducteur (3111, 3101) est au contact par la sortie principale d'un circuit intégré alimenté par les conducteurs d'alimentation (311, 312, 321, 322, 331, 332) et par les conducteurs d'alimentation successifs et où le circuit intégré est muni d'une interface sans fil.

14. Module de commutation de puissance de la 13^{e} revendication où le circuit intégré comprend une interface pour enregistrer les données optiques pour être adressé par une source de lumière pulsée.

15. Module de commutation de puissance de la 13^{e} revendication où l'entrée du décodeur d'adresse d'un circuit intégré est connectée aux structures de couplage capacitif, placées parallèlement aux conducteurs d'alimentation et isolées de ceux-ci ainsi que des conducteurs d'alimentation successifs, auxquels est connecté la sortie du dispositif de commande en régime capacitif qui produit un signal uniforme sur les potentiels électriques.
